# DEMANDE DE BREVET EUROPEEN

(11) **EP 0 897 117 A1**
(43) Date de publication de la demande: **17.02.1999**
(21) Numéro de dépôt: 98402003.2
(22) Date de dépôt: 06.08.1998
(51) Int. Cl.: G01R 31/02

(54) **Dispositif de détection de défaut d'isolement électrique pour véhicule électrique hybride**

(30) Priorité: 11.08.1997 FR 9710268
(71) Demandeur: RENAULT, 92109 Boulogne-Billancourt (FR)
(72) Inventeur: Despeyroux, Bernard, 28210 Saint Laurent La Gatine (FR); Lezy, Patrick, 92360 Meudon La Foret (FR)

(57) **Abrégé**

L'invention concerne un dispositif de détection de défaut d'isolement électrique entre un ensemble de circuits alimentés par une batterie haute tension (1) et un ensemble de circuits fonctionnant avec une basse tension, très inférieure à la haute tension, comprenant un circuit détecteur (6) d'un courant de déséquilibre des fuites entre les polarités positive et négative des circuits haute tension et la masse reliant d'un côté le point milieu (M) de la batterie (1) et de l'autre la masse des circuits basse tension, et connecté à un circuit de signalisation (7) délivrant une alarme, lumineuse, acoustique ou informatique, quand la valeur de courant de déséquilibre dépasse un seuil prédéterminé.

Application aux véhicules électriques hybrides.

## Description

La présente invention concerne un dispositif de détection d'un défaut d'isolement électrique entre deux ensembles de circuits alimentés, l'un sous haute tension et l'autre sous basse tension, en particulier applicable aux véhicules électriques hybrides.

Dans un véhicule automobile utilisant l'énergie électrique, la chaîne de traction, composée d'une batterie délivrant une haute tension comprise généralement entre 100 et 300 volts, d'un contrôleur de batterie, d'un convertisseur de haute tension en basse tension et d'un moteur électrique associé à une unité de contrôle, utilise des tensions électriques élevées, très supérieures aux limites imposées par les normes de sécurité en matière de très basses tensions de sécurité. Les tensions dépassant le seuil de 42,4 volts sont considérées comme dangereuses pour les êtres humains.

Afin de réduire les risques d'électrocution des occupants d'un véhicule électrique, en cas de contact accidentel avec les éléments de la chaîne de traction électrique, l'ensemble des organes qui la composent sont isolés diélectriquement de la masse et du réseau basse tension du véhicule alimenté sous 12 volts. Cette isolation diélectrique est réalisée en ne créant pas de lien conducteur entre les organes et les câbles électriques haute tension d'une part et basse tension de l'autre. Pour avertir les utilisateurs du véhicule, conducteur et passagers, d'une rupture de cette isolation, qui peut être due par exemple aux vibrations importantes que subit le véhicule ou à l'usure mécanique des isolants, il faut équiper le véhicule d'un organe de surveillance destiné à détecter les éventuels défauts d'isolement.

Une solution actuelle consiste à créer un défaut de faible valeur sur les bornes positive et négative de la haute tension et à lire, à intervalles de temps réguliers, la valeur exacte de la résistance de défaut. L'inconvénient de cette solution tient au fait que l'on déplace le défaut d'un point à un autre, entraînant la charge puis la décharge de capacités parasites. Cela provoque l'apparition de courants électriques donnant de fausses alertes.

La présente invention résout ces inconvénients en proposant un dispositif de détection de défaut d'isolement électrique, qui est sensible au courant de déséquilibre des fuites entre les polarités positive et négative des circuits haute tension et la masse, notamment d'un véhicule électrique.

Pour cela, l'objet de l'invention est un dispositif de détection de défaut d'isolement électrique entre un ensemble de circuits alimentés par une batterie haute tension et un ensemble de circuits fonctionnant avec une basse tension, très inférieure à la haute tension, caractérisé en ce qu'il comprend un circuit détecteur d'un courant de déséquilibre des fuites entre les polarités positive et négative des circuits haute tension et la masse, reliant d'un côté le point milieu de la batterie haute tension et de l'autre côté la masse des circuits basse tension, et connecté à un circuit de signalisation délivrant une alarme quand la valeur du courant de défaut dépasse un seuil prédéterminé.

Selon une deuxième caractéristique de l'invention, le dispositif de détection de défaut d'isolement électrique comprend de plus, dans le cas où le point milieu de la batterie haute tension est inaccessible physiquement, deux résistances de mesure qui sont placées en série entre les bornes négative et positive de la batterie, de valeurs égales pour déterminer un point milieu fictif.

Selon une autre caractéristique de l'invention, le circuit détecteur de courant est de type électronique, bi-directionnel et à hystérésis.

D'autres caractéristiques et avantages de l'invention apparaîtront à la lecture de la description suivante d'un exemple non limitatif de réalisation, illustrée par les figures suivantes qui sont :
- figure 1 : un schéma électrique de principe de la détection d'un défaut d'isolement selon l'invention, dans le cas d'un point milieu de batterie accessible;
- figure 2 : un schéma électrique d'une détection de défaut d'isolement selon l'invention par un dispositif sensible en courant;
- figure 3 : un schéma électrique d'une détection de défaut d'isolement selon l'invention par un dispositif sensible en tension;
- figure 4 : un schéma électrique de principe de la détection d'un défaut d'isolement selon l'invention, dans le cas d'un point milieu de batterie inaccessible physiquement;
- figure 5 : un premier exemple de réalisation d'un dispositif de détection de défaut d'isolement selon l'invention, sensible en courant, électronique bi-directionnel à hystérésis;
- figures 6a et 6b : deux exemples de réalisation d'un dispositif de détection selon l'invention, de type électro-mécanique, sensibles respectivement en tension et en courant;
- figures 7a, 8a, 9a et 7b, 8b et 9b : d'autres exemples de réalisation d'un dispositif de détection selon l'invention, de type électronique, respectivement unipolaires et bipolaires.

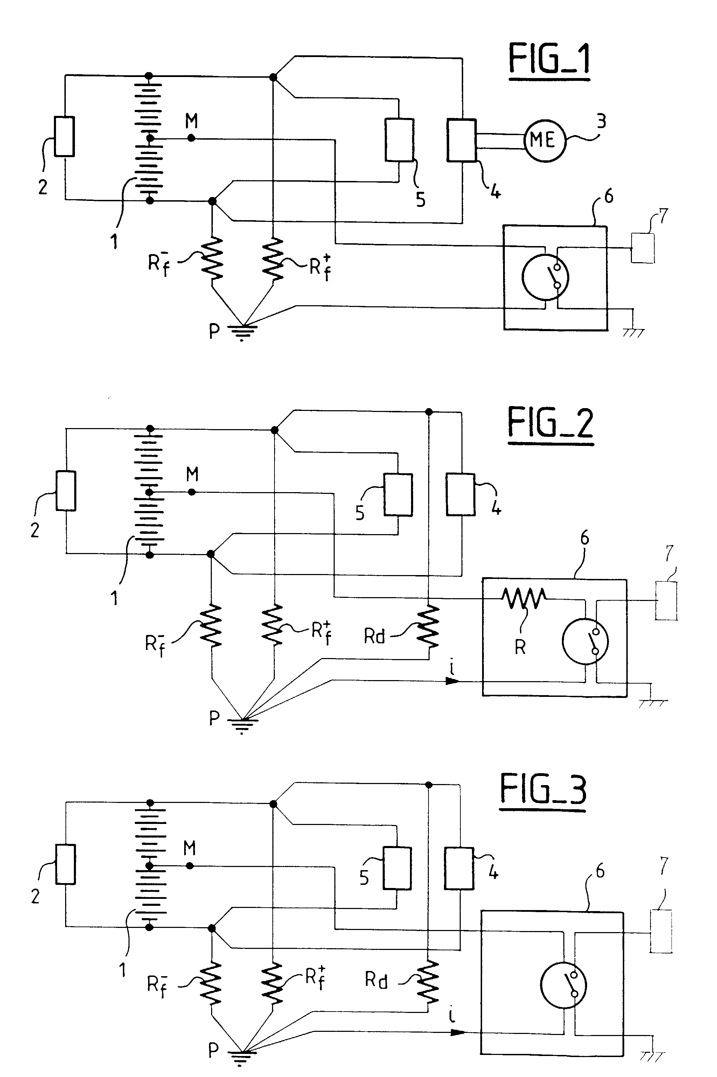

La figure 1 est un schéma électrique de principe d'une détection de défaut d'isolement, selon l'invention, entre d'une part les éléments de la chaîne de traction d'un véhicule électrique utilisant des tensions élevées et d'autre part, la masse du véhicule et les organes de son réseau alimentés en basse tension, généralement 12 volts. La chaîne de traction électrique comporte notamment une batterie 1, composée de plusieurs éléments délivrant une haute tension, généralement comprise entre 100 et 300 volts, à laquelle est associé un contrôleur de batterie 2 et destinée à alimenter un moteur électrique 3. Ce moteur est piloté par une unité de contrôle 4, fonctionnant sous basse tension obtenue à partir d'un convertisseur 5 de haute tension en basse tension.
Pour éviter les risques d'électrocution des occupants du véhicule, l'ensemble des organes sous haute tension est isolé diélectriquement, notamment par de l'air, de la masse et du réseau basse tension du véhicule. Le dispositif de détection de défaut d'isolement selon l'invention est sensible au courant de déséquilibre des fuites entre les polarités positive et négative des circuits haute tension et la masse du véhicule. Par sa présence, il supprime l'isolation électrique entre la haute et la basse tension, aussi sa conception et sa réalisation doivent être fiables et respecter notamment les principaux points suivants :
- limiter à des valeurs faibles tout courant susceptible de traverser le dispositif détecteur ;
- respecter les distances dans l'air et les longueurs de lignes de fuite entre les circuits haute et basse tensions.

Sur le schéma de la figure 1, le dispositif détecteur 6 est relié au point milieu M de la batterie 1 qui délivre une tension V_{HT} élevée.

Par rapport à ce point M servant de référence haute tension, V_{ref}, la borne positive de la batterie est à un potentiel positif égal à la moitié de la tension V_{HT}, soit + 1/2V_{HT}, alors que la borne négative de la batterie est à un potentiel négatif égal à - 1/2V_{HT}.

Si les résistances de fuite R⁺ _{f} et R⁻ _{f}, existant entre les bornes positive et négative respectivement de la batterie et la masse du véhicule, sont égales et de valeurs élevées, leur point commun P est au potentiel de référence V_{ref} de sorte que la tension aux bornes du détecteur est faible et que le courant dans le dispositif de détection 6 est nul, à condition que l'impédance du détecteur soit faible devant les résistances de fuite.

Dans le cas où un défaut apparaît comme dans le cas des figures 2, 3 et 4, l'équilibre entre le potentiel de la masse du véhicule au point P et celui du point milieu M de la batterie est rompu et le dispositif de détection 6 réagit soit à la différence de tension entre les points M et P, soit au courant de défaut qui le traverse.
Avec un détecteur sensible au courant, donc ayant une impédance relativement basse, comme c'est le cas sur la figure 2, si un défaut existe entre la borne positive de la batterie 1 et la masse du véhicule, symbolisé par une résistance de défaut R_{d}, un courant de défaut i apparaît et circule du point commun P vers le point de référence M à la tension V_{ref}, en traversant le dispositif de détection 6 et une résistance de mesure R haute tension, connectée en série entre le point milieu de la batterie et le dispositif détecteur lui permettant de résister à la tension de la batterie à ses bornes. Cette résistance de mesure permet au détecteur sensible au courant, donc à basse impédance, de résister à l'application de la tension de la batterie à ses bornes. Si la valeur de ce courant de défaut dépasse un seuil prédéterminé, un signal d'alarme est activé.

La figure 3 concerne un dispositif détecteur de défaut sensible en tension, réalisant une mesure du déséquilibre de tension entre le potentiel de la masse du véhicule et celui V_{ref} du point milieu M de la batterie 1.

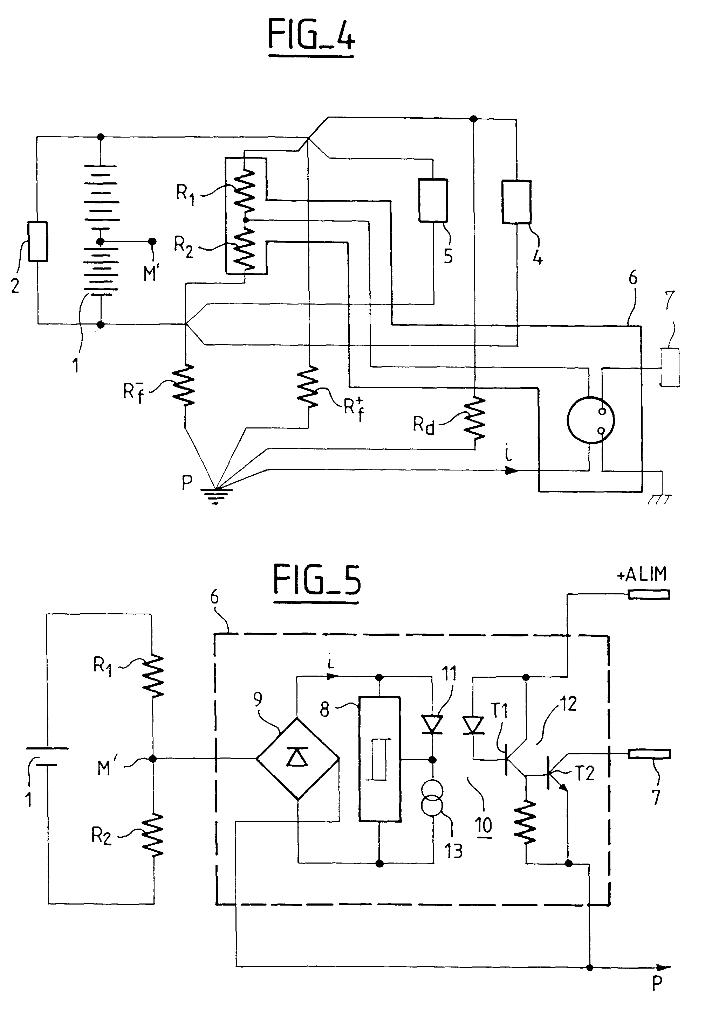

Sur le schéma de la figure 4, dans lequel le point milieu de la batterie haute tension 1 est inaccessible physiquement, on place en série deux résistances de mesure R₁ et R₂ entre les bornes positive et négative de la batterie, de valeurs égales pour déterminer un point milieu fictif M' au potentiel de référence V_{ref}. Par rapport à ce point, en l'absence de défaut d'isolement, la borne positive de la batterie est à un potentiel positif égal à +1/2V_{HT} et la borne négative est à un potentiel négatif égal à -1/2V_{HT}. Les résistances de fuite R⁺ _{f} et R⁻ _{f} existant respectivement entre chacune des deux bornes de la batterie et la masse du véhicule, sont aussi de valeurs égales et leur point commun P est au potentiel de référence V_{ref}. Aucun courant ne circule donc dans le dispositif détecteur connecté entre le point milieu fictif M' de la batterie haute tension et le point commun P des résistances de fuite.

Dans le cas où un défaut d'isolement apparaît, en particulier entre la borne positive de la batterie et la masse du véhicule, un courant de défaut i circule du point commun P des résistances de fuite vers la borne négative de la batterie en traversant le dispositif de détection 6 et la résistance R₂ de mesure reliée entre ce dernier et la borne négative. Dans ce mode de réalisation également, si le courant de défaut dépasse un seuil prédéterminé, un signal d'alarme est activé.

Ainsi, le dispositif de détection selon l'invention doit réaliser une liaison entre le point milieu M de la batterie haute tension, que ce point soit réel ou fictif, et la masse des circuits basse tension et assurer la détection d'un courant de défaut.

Pour cela, il comprend un circuit détecteur d'un courant de défaut, déclenchant une alarme par un circuit de signalisation. Ce circuit détecteur à seuil donne une mesure du défaut soit par une mesure du courant qui le traverse soit par une mesure du déséquilibre de tension qu'il provoque. Une alarme est ensuite donnée au franchissement d'un seuil en courant ou en tension, avec possibilité de tenir compte de la polarité ou non. Pour éviter les fausses alarmes, le circuit détecteur est à hystérésis ou bien on lui adjoint un dispositif de filtrage analogique en fonction du temps, de type RC ou de type LC, de la mesure. Pour garantir la sécurité des personnes, le dispositif de détection doit être fiable et prévoir la limitation des courants qui y circulent en raison de la liaison aux circuits haute tension, aussi bien en fonctionnement normal qu'en fonctionnement anormal. Le circuit de signalisation peut délivrer une alarme lumineuse ou acoustique, ou bien un signal d'alarme à un calculateur électronique de traitement.

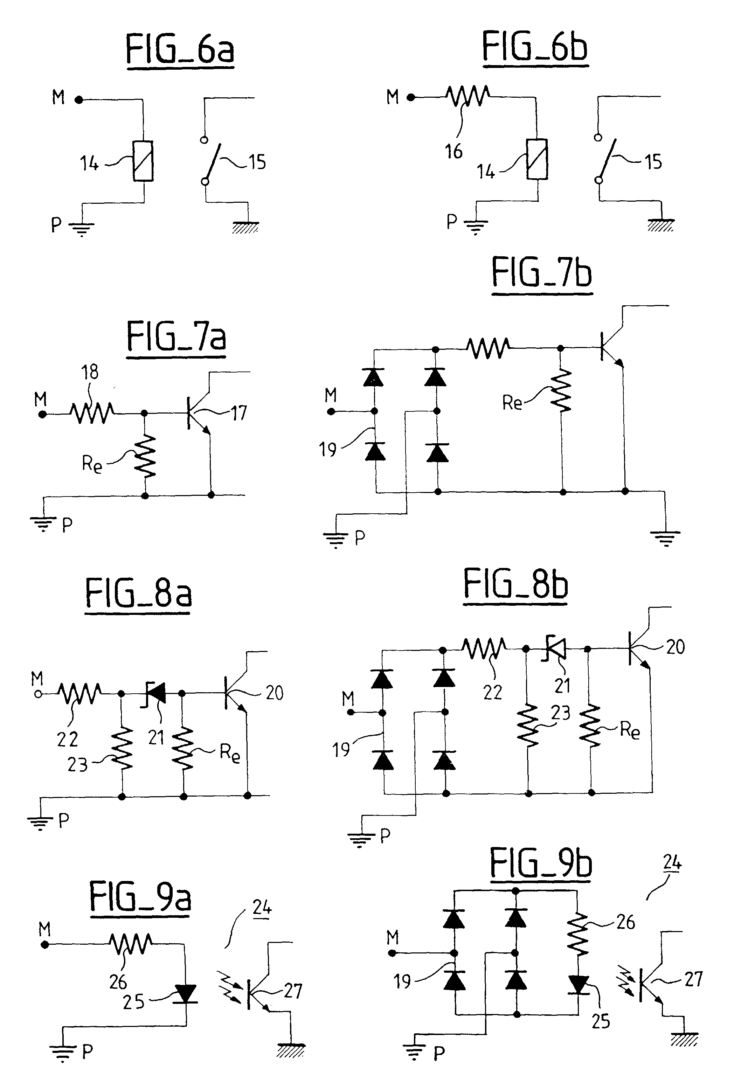

La figure 5 est un premier exemple de réalisation d'un dispositif de détection de défaut d'isolement selon l'invention, de type électronique, reliant un point milieu M' artificiel de la batterie haute tension, créé par deux résistances R₁ et R₂, à un circuit de signalisation 7. Il comprend un circuit détecteur de courant de déséquilibre 8 à seuil sensible en courant, avec un hystérésis pour éviter que le signal soit fluctuant en cas de défauts à la limite de détection ou de défauts dont la valeur évolue. Il comprend également un pont de diodes 9, pour le rendre bi-directionnel, c'est-à-dire indifférent à la polarité de la batterie sur laquelle le défaut s'est créé, ainsi qu'un circuit de commande 10 du circuit de signalisation 7. Ce circuit de commande 10 comporte d'une part une diode 11 électroluminescente et d'autre part, un photocoupleur 12, relié au circuit de signalisation 7 et constitué par une diode et deux transistors T₁ et T₂, et alimenté en basse tension.

Pour protéger la diode électroluminescente 11 des valeurs éventuellement trop élevées de la tension d'entrée du détecteur, on branche un circuit générateur de courant 13 en sortie de ce détecteur à seuil 8.

Enfin, pour assurer la limitation du courant de défaut dans le détecteur, le dispositif comprend de plus deux résistances R₁ et R₂ linéaires en série, reliées respectivement à la borne positive et à la borne négative de la batterie, de valeurs égales et élevées. Dans un exemple particulier non limitatif, afin de limiter le courant à 2,3 mA, ces résistances sont choisies égales à 100 kΩ avec une puissance nominale égale à 3 Watts, très supérieure à la puissance maximale possible qui est de 529 mWatts.

Si un courant i de défaut passe dans le circuit détecteur de courant 8, et est supérieur au seuil de courant, fixé par exemple à 1,2 mA, la diode électroluminescente 11 s'allume, créant un courant qui circule dans les deux transistors T₁ et T₂ du circuit de commande 10, qui envoie à son tour un signal de commande au circuit de signalisation 7.

En raison du phénomène d'hystérésis du détecteur de courant 8, la diode électroluminescente s'éteint si le courant qui le traverse est inférieur à un second seuil, plus petit que le seuil de déclenchement de la diode, par exemple de valeur égale à 0,6 mA.

Les figures 6a et 6b sont un deuxième exemple de réalisation d'un dispositif de détection de défaut d'isolement, de type électro-mécanique, comprenant une bobine haute tension 14 disposée en face d'un relais électro-mécanique 15, dont la tension de déclenchement est élevée. Le dispositif de la figure 6a est sensible à la tension et celui de la figure 6b est sensible au courant, c'est pourquoi une résistance de protection 16 est placée en série avec la bobine 14.

Les figures 7a à 9b sont des exemples de réalisation de dispositif de détection de défaut d'isolement de type électronique, dont ceux des figures 7a, 8a et 9a sont unipolaires et ceux des figures 7b, 8b et 9b sont bipolaires grâce à un pont de diodes 19 qui les rend sensibles à des déséquilibres dans les deux directions.

Sur la figure 7a, le dispositif de détection est sensible au courant et comprend un transistor 17 de petite puissance, avec sa résistance d'émetteur Rₑ, protégé par une résistance 18. Sur la figure 7b, ce même dispositif est bipolaire grâce au pont de diodes 19 placé entre le point milieu de la batterie haute tension, qu'il soit réel ou fictif, et le point commun P aux résistances de fuite.

Sur la figure 8a, le dispositif de détection est sensible en tension, et comprend, en plus d'un transistor 20 et de sa résistance d'émetteur Rₑ, une diode Zéner 21, dont le seuil de basculement est ajusté par deux résistances 22 et 23. Dès que le déséquilibre en tension est supérieur à la tension de la diode Zéner, le transistor conduit.

La figure 8b correspond à un dispositif de détection similaire au précédent, mais doté d'un pont de diodes 19 pour être bipolaire.

Sur la figure 9a, le dispositif de détection est sensible en courant, avec des entrées et sorties isolées par un photo-coupleur 24, constitué du côté de la batterie haute tension par une diode électroluminescente 25 et sa résistance de protection 26 et, du côté du dispositif de signalisation d'un défaut, par un photo-transistor 27. La figure 9b correspond à un dispositif bipolaire.

Les schémas électroniques représentés sur ces différentes figures donnent une alarme pour un déséquilibre donnant une tension positive. Des schémas semblables avec des transistors PNP, et non plus NPN, donneraient une sensibilité à des déséquilibres négatifs.

## Revendications

1. Dispositif de détection de défaut d'isolement électrique entre un ensemble de circuits alimentés par une batterie haute tension et un ensemble de circuits fonctionnant avec une basse tension, très inférieure à la haute tension, caractérisé en ce qu'il comprend un circuit détecteur (6) d'un courant de déséquilibre des fuites entre les polarités positive et négative des circuits haute tension et la masse, reliant d'un côté le point milieu (M) de la batterie (1) haute tension et de l'autre la masse des circuits basse tension, et connecté à un circuit de signalisation (7) délivrant une alarme quand la valeur du courant de déséquilibre dépasse un seuil prédéterminé.

2. Dispositif de détection selon la revendication 1, caractérisé en ce que, le point milieu de la batterie (1) haute tension étant inaccessible physiquement, deux résistances de mesure (R₁ et R₂) sont placées en série entre les bornes positive et négative de la batterie, de valeurs égales pour déterminer un point milieu fictif (M').

3. Dispositif de détection selon l'une des revendications 1 ou 2, caractérisé en ce que le circuit détecteur (6) d'un courant de déséquilibre est sensible en courant et, comprenant une résistance de mesure (R) haute tension, connectée en série entre le point milieu (M) de la batterie (1) et le dispositif détecteur (6) et de valeur prédéterminée pour protéger ledit dispositif détecteur de la tension de la batterie appliquée à ses bornes, délivre une mesure du courant qui le traverse.

4. Dispositif de détection selon l'une des revendications 1 ou 2, caractérisé en ce que le circuit détecteur (6) d'un courant de déséquilibre est sensible en tension et délivre une mesure du déséquilibre de tension qu'il provoque à ses bornes.

5. Dispositif de détection selon l'une des revendications 3 ou 4, caractérisé en ce qu'il est bidirectionnel, comprenant un pont de diodes (9-19) en entrée destiné à le rendre sensible à des déséquilibres sur les deux polarités positive d'une part et négative d'autre part des circuits haute tension.

6. Dispositif de détection selon l'une des revendications 3, 4 ou 5, caractérisé en ce que le circuit détecteur (6) d'un courant de déséquilibre fonctionne avec un hystérésis dont le seuil de montée est supérieur au seuil de descente.

7. Dispositif de détection selon l'une des revendications 3, 4 ou 5, caractérisé en ce que le circuit détecteur (6) d'un courant de déséquilibre comporte un circuit de filtrage analogique, en fonction du temps, de la mesure du courant.

8. Dispositif de détection selon la revendication 1 ou 2, caractérisé en ce que le circuit de signalisation (7) délivre une alarme lumineuse ou acoustique.

9. Dispositif de détection selon la revendication 1 ou 2, caractérisé en ce que le circuit de signalisation (7) délivre un signal d'alarme à un calculateur électronique de traitement.

10. Dispositif de détection selon l'une des revendications 3 ou 4, caractérisé en ce qu'il est de type électronique, comprenant une bobine haute tension (14), disposée en face d'un relais électro-mécanique (15).

11. Dispositif de détection selon les revendications 2, 3, 5 et 6, caractérisé en ce qu'il est de type électronique et relie un point milieu (M') artificiel de la batterie haute tension (1), créé par deux résistances de mesure (R₁ et R₂), à un circuit de signalisation (7) commandé par un circuit électronique (10) comportant d'une part une diode (11) électroluminescente et d'autre part un photocoupleur (12), et en ce qu'il est constitué par un pont de diodes (9) relié à un circuit détecteur (8) sensible en courant, de type à seuil avec hystérésis, en sortie duquel est branché un circuit générateur de courant (13) destiné à protéger la diode électroluminescente (11) de la tension d'entrée du détecteur.

12. Dispositif de détection selon l'une des revendications 1, 2 ou 3, caractérisé en ce qu'il est de type électronique et le circuit détecteur (6) d'un courant de déséquilibre est sensible en courant et comprend un transistor (17) de petite puissance, protégé par une résistance (18).

13. Dispositif de détection selon l'une des revendications 1, 2 ou 4, caractérisé en ce qu'il est de type électronique et le circuit détecteur (6) d'un courant de déséquilibre est sensible en tension et comprend une diode Zéner (21), dont le seuil de basculement est ajusté par deux résistances (22 et 23) et reliée à l'émetteur d'un transistor (20).

14. Dispositif de détection selon l'une des revendications 1, 2 ou 3, caractérisé en ce qu'il est de type électronique et le circuit détecteur (6) d'un courant de déséquilibre est sensible en courant et est constitué, du côté de la batterie haute tension, par une diode électroluminescente (25) et sa résistance de protection (26) et, du côté du dispositif de signalisation, par un photo-transistor (27).

15. Dispositif de détection selon les revendications 12, 13 et 14, caractérisé en ce qu'il comprend de plus un pont de diodes (19) placé entre le point milieu de la batterie haute tension et le point commun aux résistances de fuite.
